(19) Europäisches Patentamt
European Patent Office
Office européen des brevets

(11) **EP 4 280 398 A1**

(12) **EUROPEAN PATENT APPLICATION**

(43) Date of publication:
**22.11.2023 Bulletin 2023/47**

(21) Application number: **22173820.6**

(22) Date of filing: **17.05.2022**

(51) International Patent Classification (IPC):
*H01S 3/067* (2006.01)    *H01S 5/024* (2006.01)

(52) Cooperative Patent Classification (CPC):
**H01S 3/06791; H01S 3/0675; H01S 5/024**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **NKT Photonics A/S**
**3460 Birkerød (DK)**

(72) Inventor: **VARMING, Poul**
**3460 Birkerød (DK)**

(74) Representative: **Zacco Denmark A/S**
**Arne Jacobsens Allé 15**
**2300 Copenhagen S (DK)**

(54) **TUNABLE LASER DEVICE WITH FREQUENCY STABILIZATION AND LOW FREQUENCY-NOISE**

(57)    Disclosed is a tunable laser device, comprising: a tunable fiber laser and a laser-control module, wherein: the tunable fiber laser is configured to generate laser light having a center wavelength controlled by one or more Bragg grating(s) in a first fiber, and the laser-control module is configured to receive at least a portion of the laser light generated by the tunable fiber laser, to generate a stabilizing control-signal and to feed the control- signal back to the tunable fiber laser for stabilizing the center wavelength, and the laser-control module comprises a wavelength discriminating element comprising an etalon having one or more etalon-resonance(s), wherein the etalon is formed by one or more Bragg grating(s) in a second fiber, such that the etalon-resonances(s) are controlled by the one or more Bragg grating(s) in the second fiber.

FIG. 1

EP 4 280 398 A1

## Description

### Field of the invention

The present disclosure relates generally to a tunable laser device. More specifically, the present disclosure relates to providing a tunable laser device that is frequency stabilized. Most specifically, the present disclosure relates to providing a tunable laser device that has low frequency noise.

### Background

Tunable laser devices are known in the field. Further, single frequency fiber lasers are commonly known to produce laser light with a very high degree of frequency stability and a corresponding very low level of frequency-noise. An example of a tunable laser device, such as a fiber laser with frequency discriminating element, that is frequency stabilized and exhibit low frequency noise is disclosed in WO 2013/117199. Preferably, the frequency discriminating element of WO 2013/117199 is made from solid silica, such as a solid silica based Fabry-Perot interferometer with mirrors and placed outside a laser cavity. When the frequency discriminating element is a solid silica based Fabry-Perot interferometer, a combination of high finesse and a suitable free spectral range can be obtained using a small interferometer. In designing frequency discriminating elements, it is well-known that such must have a high slope steepness, which can be obtained by increasing the finesse or reducing the free spectral range of the interferometer. However, it is difficult to manufacture a small tunable interferometer with very high slope steepness.

To solve this problem, high finesse interferometers have been produced in fibers with Bragg gratings therein. In other words, fiber-based Bragg gratings configured to operate as Fabry-Perot interferometers have been proposed to be used as a frequency discriminating element.

An example of a tunable laser device based on a diode laser in combination with a frequency discriminating element in the form of a fiber Bragg grating Fabry-Perot cavity is disclosed in the article "Subkilohertz linewidth reduction of a DFB diode laser using self-injection locking with a fiber Bragg grating Fabry-Perot cavity", by Fang Wei et al. Optics Express 17406, Vol. 24, No. 15, 25 Jul 2016. The setup in the article relies on a complex self-injection locking system that however reports a control of the frequency of the laser, and a drastic reduction of the phase/frequency noise.

Another example of a tunable laser device in combination with a frequency discriminating element in the form of a fiber Bragg grating is disclosed in US 2016/0216369. This disclosure is directed to controlling the frequency of the laser based on the frequency discrimination element.

A third example of a tunable laser device in combination with a frequency discriminating element in the form of a fiber Bragg grating, however a narrow band phase-shifted fiber Bragg graging, is disclosed in CN 103986053A. Also this disclosure is directed to controlling the frequency of the laser based on the frequency discrimination element.

In the prior art as described above, the stabilization of the laser, for example after wavelength tuning, takes long time and/or relies on complex setups.

### Summary

It is an objective of this disclosure to provide a tunable laser device that overcomes the problems of the prior art.

Further, it is an objective of this disclosure to decrease the frequency/phase noise of tunable laser devices, in particular of tunable fiber lasers.

Even further, it is an objective of this disclosure to provide a tunable laser device that generates laser light and that comprises a tunable fiber laser and a laser-control module that acts to stabilize the frequency of the laser and provide a high frequency stability of the laser light, while simultaneously maintain wavelength tunability of the device.

Last, but not least, it is an objective of this disclosure to provide a tunable laser device that stabilizes the frequency of the tunable laser device in an efficient and easy manner.

These and other objectives have been solved by the tunable laser device as defined in the claims and as described below in the present disclosure.

In one aspect of the disclosure, there is disclosed a tunable laser device, comprising:

- a tunable fiber laser and a laser-control module, wherein:

  ○ the tunable fiber laser is configured to generate laser light having a center wavelength controlled by one or more Bragg grating(s) in a first fiber, and
  ○ the laser-control module is configured to receive at least a portion of the laser light generated by the tunable fiber laser, to generate a stabilizing control-signal and to feed the control-signal back to the tunable fiber laser for stabilizing the center wavelength, and

◦ the laser-control module comprises a wavelength discriminating element comprising an etalon having one or more etalon-resonance(s), wherein the etalon is formed by one or more Bragg grating(s) in a second fiber, such that the etalon-resonances(s) are controlled by the one or more Bragg grating(s) in the second fiber.

The first fiber and the second fiber are configured to be controlled by a fiber-control module, wherein the fiber-control module is configured for transmitting a tuning control-signal related to defining a first temperature of the first fiber and a second temperature of the second fiber.

In this manner, the fiber-control module is responsible for both:

◦ shifting the center wavelength by modifying the one or more Bragg grating(s) in the first fiber, and
◦ shifting the etalon resonance(s) by modifying the one or more Bragg gating(s) in the second fiber.

Accordingly, the shifting of the etalon resonance(s) may advantageously be shifted in the same manner as the center wavelength, and thus in an efficient and easy manner.

The fiber-control module according to the present disclosure is configured for transmitting a tuning control-signal related to defining a first temperature of the first fiber and a second temperature of the second fiber. In this context, it is understood that the tuning control-signal that is transmitted to both the first and the second fiber originates from a single signal. The single signal provides an efficient and easy control of the two fibers. Clearly, the single original signal may be split into two signals, for example if two fibers are separated from each other and not in thermal contract with each other. However, most preferably, the single signal is kept as a single signal, for example in an embodiment when the two fibers are in thermal contact with each other. The two fibers may be in thermal contact with each other via one or more substrate(s) and/or via one or more thermal carrier(s) as will be described in the below.

Typically, a fiber laser wavelength is controlled or tuned by only a single signal that is independent from the signal being transmitted to control the etalon. Examples of such are disclosed in WO 2013/117199 and 2016/0216369. A fiber laser may however also be controlled by more than one signal, such as disclosed in us2016216369, but such signals are also independent from the signal being transmitted to control the etalon.

In contrast to such setups, the present disclosure provides a fiber laser that, in addition to having the laser phase noise reduced by a stabilizing control-signal, the laser wavelength is controlled by a tuning control-signal that is also used to control the etalon resonance(s). In other words, the present disclosure provides a fiber laser that is controlled or tuned by a signal that is also dependent from the signal being transmitted to control the etalon. This dependency provides efficient and easy control of the two fibers.

Surprisingly, the inventor of the present disclosure also found that using a control module that is responsible for both shifting the center wavelength of a laser and shifting the etalon resonance(s) of an etalon can be applied not only to a fiber laser, but to a variety of laser types.

Accordingly, in a second aspect of the disclosure is provided a tunable laser device, comprising:

- a tunable laser and a laser-control module, wherein:

◦ the tunable laser is configured to generate laser light having a center wavelength, and
◦ the laser-control module is configured to receive at least a portion of the laser light generated by the tunable laser, to generate a stabilizing control-signal and to feed the control-signal back to the tunable laser for stabilizing the center wavelength, and
◦ the laser-control module comprises a wavelength discriminating element comprising an etalon having one or more etalon-resonance(s),

wherein the tunable laser and the etalon are configured to be controlled by a common-control module, wherein the common-control module is configured for transmitting a tuning control-signal related to defining a first temperature of the tunable laser and a second temperature of the etalon, whereby the common-control module is responsible for both:

◦ shifting the center wavelength of the tunable laser, and
◦ shifting the etalon resonance(s) of the etalon.

In a preferred embodiment of the second aspect of the disclosure, the tunable laser is a planar waveguide laser, and the etalon is formed in a material with identical material properties as the planar waveguide laser, such as the planar waveguide and the etalon have identical thermal expansions. In a first preferred embodiment, the material of the planer waveguide laser and the etalon is formed by InP, or another low-loss passive material.

In another preferred embodiment of the second aspect of the disclosure, the tunable laser is a laser comprising one or more Bragg grating(s), such as a fiber laser, and the etalon is formed in a material with identical material properties as the tunable laser, such as with identical thermal expansions. For example, the tunable laser and the etalon may be formed by identical materials, such as low-loss passive materials, for example such as InP.

In some embodiments of the second aspect of the disclosure, the tunable laser is a diode laser, or a solid-state laser. In these embodiments, and the previous preferred embodiments, the common-control module may transmit the tuning control-signal related to defining a first temperature of the tunable laser and a second temperature of the etalon due to the tunable laser and the etalon being in thermal contact with each other. When the materials of the tunable laser and the etalon have identical thermal expansion, both the thermal tuning of the center wavelength and the thermal tuning of the etalon wavelength resonance(s) are efficiently controlled together and dependently.

## Brief description of the drawings

The above and/or additional objects, features and advantages of the present disclosure, will be further described by the following illustrative and non-limiting detailed description of embodiments of the present disclosure, with reference to the appended drawing(s), wherein:

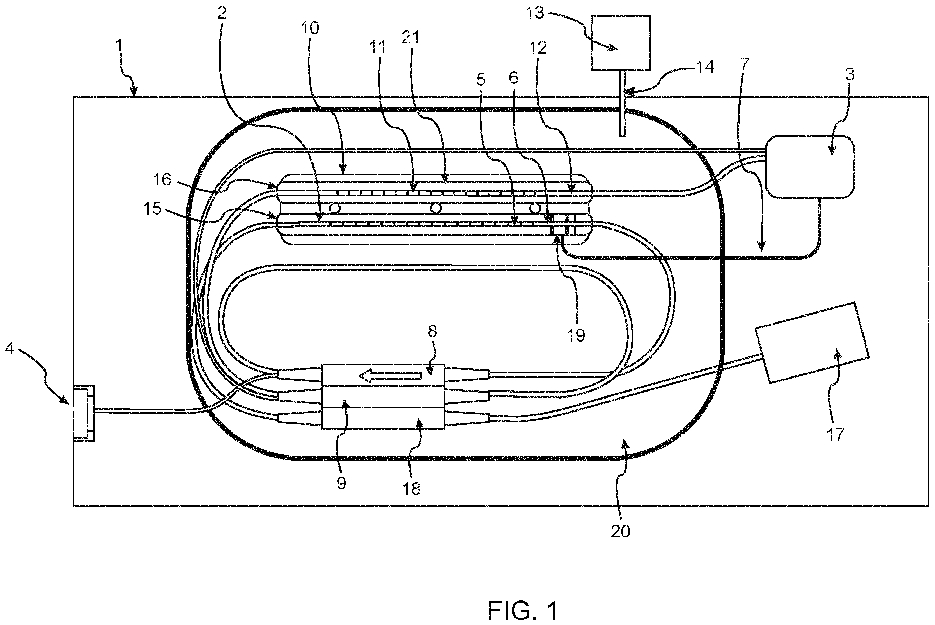

**Fig. 1** shows an example of the tunable laser device according to the present disclosure.

## Detailed description

### The tuning control-signal

In one embodiment of the tunable laser device, the tuning control-signal is communicated to a thermal carrier in thermal contact with both the first fiber and the second fiber.

In a preferred embodiment of the tunable laser device, the tuning control-signal is an electric signal communicated to one or more thermo-electric element(s) in thermal contact with the first fiber and the second fiber. The thermo-electric element(s) may for example be a Peltier element, a thin film heating element or another resistive heating elements.

Preferably, the tuning control-signal may be communicated to a single substrate configured to hold the first fiber and the second fiber. When using a single substrate, the single substrate may be in thermal contact with a thermal carrier.

More preferably, the tuning control-signal may be communicated to a first substate configured to hold the first fiber, and the tuning control-signal may be communicated to a second substrate configured to hold the second fiber. When using two substrates, the first substrate and the second substrate may be in thermal contact with a thermal carrier to provide thermal contact between the thermal carrier and both the first fiber and the second fiber. Accordingly, the tuning control-signal may simply be transmitted to the thermal carrier, for example to a Peltier element located inside the thermal carrier, such that the temperature of the Peltier element is distributed in the thermal carrier and to both of the fibers.

Using a single substrate or two substrates configured to hold the first and second fiber may ensure that precise wavelength tuning is achieved.

This may for example be ensured because the temperature of the first fiber, i.e. of the tunable fiber laser, may be defined via the temperature of the single substrate or the temperature of the two substrates.

A relationship between the first fiber and a substrate holding the first fiber is defined by a combination of the thermo-optic and the elasto-optic effect caused by strain from the thermal expansion of the substrate(s), described as follows:

$$\frac{1}{\lambda}\frac{d\lambda}{dT} = \frac{1}{n}\frac{dn}{dT} + \alpha_s - p_e(\alpha_s - \alpha_f) \qquad (1)$$

where T is the temperature, $\lambda$ is the center wavelength of the laser, and $\alpha_s$ is the thermal expansion coefficient of the substrate. The first fiber has the thermo-optic coefficient (dn/dT)/n, where n is the refractive index of the first fiber, $p_e$ is the elasto-optic coefficient of the first fiber, and $\alpha_f$ is the thermal expansion of the first fiber.

In other words, the center wavelength of the first fiber may thus be defined and tuned by the temperature of the single or the first substrate, most preferably in combination with a thermal carrier.

According to the embodiments described above, defining the thermal carrier, the thermal carrier may be made by a material with high thermal conductivity, such as aluminum or copper. The thermal carrier may ensure that the heat is distributed efficiently and evenly along the substrate(s) and/or the fiber(s).

In a most preferred embodiment of the tunable laser device, the first and second substrate are formed by materials having identical thermal expansion, and wherein the first temperature and the second temperature are identical, such that said first and second substrates are thermally expanded in the same manner. As described just above, a thermal carrier may be responsible for distributing the heat such that the temperature of the first and second substrate is identical. In other words, the thermal carrier may be responsible for providing that the first temperature and the second temperature are identical. The first and second substrate may for example be formed by ceramic. In this manner, the center wavelength of the laser would be affected by the temperature of the first fiber according to the relationship given by equation (1) and the etalon resonance(s) of the second fiber would be affected by the temperature of the second fiber according to the same equation (1). As just described, at least $\alpha_s$ of the first substrate would be identical to $\alpha_s$ of the second substrate. The term "identical" is in this disclosure understood to be within a difference of maximum 10%, such as with a difference of less than 5%, or such as with a difference of less than 1%.

In relation to the preferred embodiment described above, it may further be advantageous to also have the first fiber and the second fiber formed by materials having identical thermal expansion. When the temperatures of the two substrates are identical, it would imply that said first and second fiber are thermally expanded in the same manner.

However, in other embodiments, not necessarily in relation to the preferred embodiment described above, the first fiber and the second fiber are formed by materials having identical thermal expansion, and wherein the first temperature and the second temperature are identical, such that said first and second fiber are thermally expanded in the same manner.

The identical temperature may not need to be defined by a thermal carrier as described above. Instead, the identical temperature may in principle be provided directly via a single substrate or directly via the first and the second substrate. For example, the substrates(s) may be formed by aluminum and be controlled by one or more thermo-electric element(s) located inside or in direct contact with the substrate(s), thereby directly controlling the temperature of the substrate(s).

As understood from the above, the thermal carrier is an example of providing a temperature to the substrates in an indirect manner. Hence, the first and second temperature according to the present disclosure can both be provided to the fiber(s) and/or the substrates(s) in a direct manner or in an indirect manner.

In some embodiments, said first and second substrate are formed by materials having different thermal expansion, and wherein the defined first temperature and the defined second temperature are identical, such that said first and second substrates are thermally expanded in the same manner. In other words, the thermal expansion of the two substrates having different thermal expansion may expand in the same manner by having different heating, i.e. different signals to the thermo-electric elements of the two substrates. Accordingly, the signals may be defined to compensate for the different thermal expansion of the two substrates. In such embodiments, the first defined temperature of the first fiber and the second defined temperature of the second fiber being identical, may for example be provided by splitting the tuning control-signal into two different signals, where the two different signals are defined by the thermal expansion of the substrates. However, these embodiments are less preferred than the preferred embodiment, where the first and second substrate are formed by materials having identical thermal expansion, and wherein the first defined temperature and the second defined temperature are identical, such that said first and second substrates are thermally expanded in the same manner.

Similarly, in some embodiments, the first fiber and the second fiber may be formed by materials having different thermal expansion, and wherein the first temperature and the second temperature are different, such that said first and second fiber are thermally expanded in the same manner. In such embodiments, the first temperature of the first fiber and the second temperature of the second fiber being identical, may for example be provided by splitting the tuning control-signal into two different signals, where the two different signals are defined by the thermal expansion of the substrates and the fibers. Again, these embodiments are less preferred than the preferred embodiment, where the first and second fiber are formed by materials having identical thermal expansion, and wherein the first temperature and the second temperature are identical, such that said first and second substrates are thermally expanded in the same manner.

The less preferred embodiments as described above may require a good understanding of the thermal expansions of the substrates and the fibers, but once this understanding is provided, the properties of the substrates can be exploited to further optimize both shifting the center wavelength and shifting the etalon resonance(s) in combination with each other.

Regardless of how the identical temperatures of the fibers are obtained, the identical thermal expansion of the fibers and/or substrates is in most preferred embodiments responsible for synchronically shifting the center wavelength of the tunable fiber laser and the etalon resonance(s).

As has been described above, it is also possible to obtain identical temperatures of the fibers even if the thermal expansion of the fibers and/substrates is different, i.e. for example if the thermal expansion of the two fibers and/or fibers differs by more than 10%. However, when the different fibers and/or different substrates are optimized to provide identical temperatures of the fibers, then the different thermal expansion of the fibers and/or substrates is in most preferred embodiments responsible for synchronically shifting the center wavelength of the tunable fiber laser and the etalon resonance(s).

Due to the synchronically wavelength shifting, there is here provided a tunable laser device, where the relative distance of the center wavelength and resonance wavelength is maintained in a very efficient manner. Typically, in the prior art, when tuning a tunable laser, the resonance wavelength is not shifted very efficiently, namely because there is no dependency between the signal that controls the tuning of the laser and the signal that controls the etalon. Hence, the solution presented in this disclosure provides an optimized tunable laser device.

To define the center wavelength of the laser, it may be important to know at least the temperature of the first fiber and/or of a substrate therefor. A thermo-electric element may be used to indirectly measure the temperature, but it may be an advantageous to directly measure the temperature.

Accordingly, in most preferred embodiments, said substrate(s) comprise(s) one or more temperature sensor(s) configured to measure the temperature of said substrate(s). The temperature sensor(s) may be one or more of a Negative Temperature Coefficient (NTC) thermistor, a Positive Temperature Coefficient (PTC) thermistor, a Resistance Temperature Detector (RTD) or a thermocouple. The temperature sensor(s) may for example be located inside a hole in the substrate(s).

The first fiber and the tunable fiber laser

In a preferred embodiment of the tunable laser device, the tunable fiber laser is a fiber DFB (distributed feedback) laser or a DBR (distributed Bragg reflector) fiber laser.

According to the tunable laser device as disclosed herein, the tunable laser device comprises a tunable fiber laser. Fiber lasers as disclosed herein are known to constitute a class of compact lasers which exhibits lower levels of frequency noise compared to many other types of similarly compact lasers.

Although the fiber laser itself is with low levels of frequency noise, the present disclosure provides an optimized tunable laser device with even lower levels of frequency noise. This is due to the etalon as has been described, and which will also be described in the following.

The second fiber and the etalon-resonance(s)

In one embodiment of the tunable laser device, the etalon in second fiber is configured with a free spectral range of less than 10 GHz, preferably less than 5 GHz, more preferably less than 2.5 GHz, most preferably around 2.0 GHz. Using a low free spectral range, as disclosed here, has a very specific advantage. This is because the fast tuning of the laser central wavelength with the stabilizing control-signal is only possible over a limited frequency range, and for this reason the free spectral range of the etalon should be smaller or similar to the fast tuning range of the laser. For example, the low free spectral range may enable stabilizing the frequency of the laser in less than 10000 ms, such as less than 1000 ms, such as less than 100 ms. The low free spectral range as disclosed here, is typically not able to practically be provided in a compact etalon such as in a solid silica based Fabry-Perot interferometer with mirrors. Using a second fiber encompassing an etalon, in addition to the first fiber, thus serves to enable a low free spectral range, which may enable stabilizing the laser frequency very efficiently and quickly. Further, as has been previously described, the second fiber also serves to provide an etalon that can be controlled synchronously to the center wavelength of the first fiber by controlling the fiber temperatures. Accordingly, the combination of both using the second fiber as an etalon and controlling it with a fiber-control module that also controls the tunable fiber laser, provides a highly improved tunable laser device.

In another embodiment of the tunable laser device, the full-width-at-half-maximum (FWHM) bandwidth of said etalon resonance(s) are configured to be less than 300 MHz, preferably less than 100 MHz, more preferably around 50 MHz. Using a low resonance FWHM bandwidth, as disclosed here, has a very specific advantage. For example, the etalon-resonance(s) is/are responsible for suppressing the frequency noise within the locking bandwidth down to less than 10000 $Hz^2$/Hz, preferably less than 100 $Hz^2$/Hz, more preferably less than 1 $Hz^2$/Hz. This provides a highly improved tunable laser device that has very low frequency noise. In combination with the etalons low free spectral range, the present disclosure provides a tunable laser device that is both efficient in being stabilized and at the same time also with low frequency noise.

More generally stated, when the tunable laser device is used with a fiber laser and a fiber with a fiber-based Fabry-Perot interferometer, according to the present disclosure, it is configured to lock the center wavelength of the fiber laser to one of the resonance(s) of the laser-control module in a very efficient manner. Moreover, the present disclosure provides a tunable laser device where the locking to the etalon resonance is achieved while the tunable laser is temperature-tuned, i.e. while the tunable laser is wavelength shifted via temperature-tuning. This produces a tunable laser device with very low levels of frequency-noise across a wide range of frequencies.

The tunable laser according to the present disclosure is thus with its low levels of frequency-noise suitable for applications such as quantum computing, quantum optics, quantum sensing, optical clocks, gravity-wave detection, high-resolution spectroscopy, and ultraprecise time and frequency transfer.

The stabilizing control-signal

In one embodiment of the tunable laser device, the stabilizing control-signal, as is fed back to the tunable fiber laser, is via one or more actuators configured to change the tension of the Bragg grating(s) in the first fiber. The one or more actuator(s) may be one or more of a piezo electric actuator, a magnetostrictive actuator and/or a thermal expansion actuator. Preferably, the one or more actuator(s) may be placed on the substrate holding the first fiber. Most preferably, only a single actuator is placed on the substrate holding the first fiber. Using only a single actuator may provide an easy control of the fiber laser. Further, in some embodiments, when using an etalon with a free low spectral range as described above, it has been found that only a single actuator needs to be used to efficiently stabilize the fiber laser. In other words, the inventor of the present disclosure has identified how it is possible to use just a single actuator to stabilize the frequency of the fiber laser as here disclosed.

Alternatively, or additionally, the stabilizing control-signal, as is fed back to lock the tunable fiber laser to an etalon resonance, is via an acousto-optic modulator configured to change the wavelength of the fiber laser.

In a preferred embodiment of the tunable laser device, the tunable laser device further comprises a balanced detector to generate the stabilizing control-signal, and wherein the stabilizing control-signal is based on the difference in power between a reference signal and the power transmitted through the frequency discriminating element.

Example 1

**Fig. 1** shows an example of an embodiment of the tunable laser device **1** according to the present disclosure. The tunable laser device **1** comprises a tunable fiber laser **2** and a laser-control module **3**. The tunable fiber laser **2** is configured to generate laser light **4**, which ends up as being transmitted as laser output. The laser light **4** has a center wavelength, which is controlled by one or more Bragg grating(s) **5** in a first fiber **6**. The laser-control module **3** is configured to receive at least a portion of the laser light **4** generated by the tunable fiber laser **2,** to generate a stabilizing control-signal **7** and to feed the control-signal **7** back to the tunable fiber laser **2** for stabilizing the center wavelength. As can be seen from **Fig. 1,** at least the portion of the laser light generated by the tunable fiber laser **2,** is received by the laser-control module **3,** by first entering a polarizing tab/isolator **8,** which splits the light into the laser output, and into light that is transmitted to a 3 dB splitter **9**. From the 3dB splitter **9,** a portion of the light is transmitted via a fiber to the laser-control module **3**. Another portion of the light is transmitted via another fiber to a wavelength discriminating element **10**. Accordingly, the tunable laser device comprises a wavelength discriminating element **10**. The wavelength discriminating element **10** comprises an etalon having one or more etalon-resonance(s), wherein the etalon is formed by one or more Bragg grating(s) **11** in a second fiber **12,** such that the etalon-resonances(s) are controlled by the one or more Bragg grating(s) **11** in the second fiber **12**.

The first fiber **6** and the second fiber **12** are configured to be controlled by a fiber-control module **13,** wherein the fiber-control module **13** is configured for transmitting a tuning control-signal **14** related to defining a first temperature of the first fiber **6** and a second temperature of the second fiber **12**. In this example, the tuning control-signal **14** is a single signal that originates from the fiber-control module **13**. The single signal is here transmitted to a thermal carrier **20,** being a plate made of aluminum. The plate is shown here with rounded corners and placed on top of the tunable laser device **1**. Accordingly, the plate is shown here as an invisible plate. The thermal carrier **20** is however with a defined thickness and configured for distributing heat. The heat comes from one or more Peltier elements, which are controlled by the tuning control-signal **14**. The Peltier elements **14** are in thermal contact with the thermal carrier **20**. In this manner, the tuning control-signal **14** is communicated to the thermal carrier. Further, the thermal carrier is in thermal contact with both the first fiber **6** and the second fiber **12**. Accordingly, the fiber-control module **13** is responsible for both: shifting the center wavelength by modifying the one or more Bragg grating(s) **5** in the first fiber **6,** and shifting the etalon wavelength by modifying the one or more Bragg gating(s) **5** in the first fiber **6**.

In **Fig. 1,** the tuning control-signal **14** is communicated to a first substate **15** configured to hold the first fiber **6**. Further, the tuning control-signal **14** is also communicated to a second substate **16** configured to hold the second fiber **12**.

Accordingly, the first substrate **15** and the second substrate **16** are in thermal contact with the thermal carrier **20** in thermal contact with both the first fiber **6** and the second fiber **12**.

As can be seen from **Fig. 1,** the fiber laser **2** is pumped by a pump laser **17** via a wavelength division multiplexing (WDM) element **18**.

As can further be seen from **Fig. 1** of the setup of the tunable laser device **1,** the present disclosure provides a compact tunable laser device 1. This has partly been achieved by using two fibers (6 and 12), but also because the two fibers (6 and 12) according to the disclosure can be placed very close to each other, in particular in thermal contact with each other. Thermal contact between an etalon and a laser is typically not desired, and mostly avoided by thermal insulation. The present disclosure takes a completely different approach and takes advantage of placing the two fibers in thermal contact with each other.

In this example, the Bragg gratings (**5** and **11**) in the first **6** and second **12** fibers are fixed by glue under tension in substrates (15 and 16) made of the same material. The substrate **15** containing the laser Bragg grating(s) **5** further has a fast actuator **19** embedded in the substrate. This actuator **19** enables fast tuning of the laser wavelength, thus enabling locking the laser wavelength to an etalon resonance using the stabilizing control-signal **7.** Since the substrates (**15** and **16**) are in thermal contact with the thermal carrier **20,** the laser wavelength and the etalon resonance(s) will change synchronously as a reaction to the tuning control signal **14.** This setup enables stabilizing the laser wavelength while the wavelength is being changed by the tuning control signal because the actuator **6** provides much faster tuning of the wavelength than the tuning from the tuning control signal **14.**

Further details of the disclosure is provided by the following items.

## Items:

1. A tunable laser device, comprising:

- a tunable fiber laser and a laser-control module, wherein:

  ◦ the tunable fiber laser is configured to generate laser light having a center wavelength controlled by one or more Bragg grating(s) in a first fiber, and
  ◦ the laser-control module is configured to receive at least a portion of the laser light generated by the tunable fiber laser, to generate a stabilizing control-signal and to feed the control-signal back to the tunable fiber laser for stabilizing the center wavelength, and
  ◦ the laser-control module comprises a wavelength discriminating element comprising an etalon having one or more etalon-resonance(s), wherein the etalon is formed by one or more Bragg grating(s) in a second fiber, such that the etalon-resonances(s) are controlled by the one or more Bragg grating(s) in the second fiber,

  wherein the first fiber and the second fiber are configured to be controlled by a fiber-control module, wherein the fiber-control module is configured for transmitting a tuning control-signal related to defining a first temperature of the first fiber and a second temperature of the second fiber, whereby the fiber-control module is responsible for both:

  ◦shifting the center wavelength by modifying the one or more Bragg grating(s) in the first fiber, and
  ◦ shifting the etalon resonance(s) by modifying the one or more Bragg gating(s) in the second fiber.

2. The tunable laser device according to item 1, wherein the tuning control-signal is communicated to a thermal carrier in thermal contact with both the first fiber and the second fiber.

3. The tunable laser device according to any of the preceding items, wherein the tuning control-signal is an electric signal communicated to one or more thermo-electric element(s) in thermal contact with the first fiber and the second fiber.

4. The tunable laser device according to item 1, wherein the tuning control-signal is communicated to a single substrate configured to hold the first fiber and the second fiber.

5. The tunable laser device according to item 4, wherein the single substrate is in thermal contact with a thermal carrier in thermal contact with both the first fiber and the second fiber.

6. The tunable laser device according to item 1, wherein the tuning control-signal is communicated to a first substate configured to hold the first fiber, and wherein the tuning control-signal is communicated to a second substrate configured to hold the second fiber.

7. The tunable laser device according to item 6, wherein the first substrate and the second substrate are in thermal contact with a thermal carrier in thermal contact with both the first fiber and the second fiber.

8. The tunable laser device according to item 2, or item 5 or item 7, wherein the thermal carrier is made by aluminum or copper.

9. The tunable laser device according to any of items 6-7, wherein said first and second substrate are formed by materials having identical thermal expansion, and wherein the first temperature and the second temperature are identical, such that said first and second substrates are thermally expanded in the same manner.

10. The tunable laser device according to any of items 6-7, wherein said first and second substrate are formed by materials having different thermal expansion, wherein the first temperature and the second temperature are identical and the tuning control-signal compensates for the different thermal expansion, such that said first and second substrates are thermally expanded in the same manner.

11. The tunable laser device according to any of the items 2-10, wherein said substrate(s) comprises one or more temperature sensors configured to measure the temperature of said substrate(s).

12. The tunable laser device according to any of the preceding items, wherein the first fiber and the second fiber are formed by materials having identical thermal expansion, and wherein the first temperature and the second temperature are identical, such that said first and second fiber are thermally expanded in the same manner.

13. The tunable laser device according to any of the preceding items, wherein the first fiber and the second fiber are formed by materials having different thermal expansion, wherein the first temperature and the second temperature are different, and the tuning control-signal compensates for the different thermal expansion, such that said first and second fiber are thermally expanded in the same manner.

14. The tunable laser device according to item 9 and/or item 12, wherein the identical thermal expansion is responsible for synchronically shifting the center wavelength of the tunable fiber laser and the etalon resonance(s).

15. The tunable laser device according to item 10 and/or item 13, wherein the different thermal expansion is responsible for synchronically shifting the center wavelength of the tunable fiber laser and the etalon resonance(s).

16. The tunable laser device according to any of the preceding items, wherein the second fiber is configured with a free spectral range of less than 10 GHz, preferably less than 5 GHz, more preferably less than 2.5 GHz, most preferably around 2.0 GHz.

17. The tunable laser device according to item 16, wherein the free spectral range is responsible for stabilizing the frequency of the laser in less than 10000 ms, such as less than 1000 ms, such as less than 100 ms.

18. The tunable laser device according to any of the preceding items, wherein the full-width-at-half-maximum (FWHM) bandwidth of said etalon resonance(s) are configured to be less than 300 MHz, preferably less than 100 MHz, more preferably around 50 MHz.

19. The tunable laser device according to item 18, wherein said etalon-resonance(s) is/are responsible for suppressing the frequency noise within the locking bandwidth down to less than 10000 $Hz^2/Hz$, preferably less than 100 $Hz^2/Hz$, more preferably less than 1 $Hz^2/Hz$.

20. The tunable laser device according to any of the preceding items, wherein the stabilizing control-signal back to the tunable fiber laser is via one or more actuators configured to change the tension of the Bragg grating(s) in the first fiber.

21. The tunable laser device according to any of the preceding items, wherein the stabilizing control-signal back to the tunable fiber laser is via an acousto-optic modulator configured to change the wavelength of the fiber laser.

22. The tunable laser device according to any of the preceding items, wherein the tunable laser device further comprises a balanced detector to generate the stabilizing control-signal, and wherein the stabilizing control-signal is based on the difference in power between a reference signal and the power transmitted through the frequency discriminating element.

**Claims**

1. A tunable laser device, comprising:

- a tunable fiber laser and a laser-control module, wherein:

  ◦ the tunable fiber laser is configured to generate laser light having a center wavelength controlled by one or more Bragg grating(s) in a first fiber, and
  ◦ the laser-control module is configured to receive at least a portion of the laser light generated by the tunable fiber laser, to generate a stabilizing control-signal and to feed the control-signal back to the tunable fiber laser for stabilizing the center wavelength, and
  ◦ the laser-control module comprises a wavelength discriminating element comprising an etalon having one or more etalon-resonance(s), wherein the etalon is formed by one or more Bragg grating(s) in a second fiber, such that the etalon-resonances(s) are controlled by the one or more Bragg grating(s) in the second fiber,

  wherein the first fiber and the second fiber are configured to be controlled by a fiber-control module, wherein the fiber-control module is configured for transmitting a tuning control-signal related to defining a first temperature of the first fiber and a second temperature of the second fiber, whereby the fiber-control module is responsible for both:

  ◦ shifting the center wavelength by modifying the one or more Bragg grating(s) in the first fiber, and
  ◦ shifting the etalon resonance(s) by modifying the one or more Bragg gating(s) in the second fiber.

2. The tunable laser device according to claim 1, wherein the tuning control-signal is communicated to a thermal carrier in thermal contact with both the first fiber and the second fiber.

3. The tunable laser device according to any of the preceding claims, wherein the tuning control-signal is an electric signal communicated to one or more thermo-electric element(s) in thermal contact with the first fiber and the second fiber.

4. The tunable laser device according to claim 1, wherein the tuning control-signal is communicated to a first substate configured to hold the first fiber, and wherein the tuning control-signal is communicated to a second substrate configured to hold the second fiber.

5. The tunable laser device according to claim 4, wherein the first substrate and the second substrate are in thermal contact with a thermal carrier in thermal contact with both the first fiber and the second fiber.

6. The tunable laser device according to claim 2 or claim 5, wherein the thermal carrier is made by aluminum or copper.

7. The tunable laser device according to any of claims 4-5, wherein said first and second substrate are formed by materials having identical thermal expansion, and wherein the first temperature and the second temperature are identical, such that said first and second substrates are thermally expanded in the same manner.

8. The tunable laser device according to any of the claims 2-7, wherein said substrate(s) comprises one or more temperature sensors configured to measure the temperature of said substrate(s).

9. The tunable laser device according to any of the preceding claims, wherein the first fiber and the second fiber are formed by materials having identical thermal expansion, and wherein the first temperature and the second temperature are identical, such that said first and second fiber are thermally expanded in the same manner.

10. The tunable laser device according to claim 7 and/or claim 9, wherein the identical thermal expansion is responsible for synchronically shifting the center wavelength of the tunable fiber laser and the etalon resonance(s).

11. The tunable laser device according to any of the preceding claims, wherein the second fiber is configured with a free spectral range of less than 2.5 GHz, most preferably around 2.0 GHz.

12. The tunable laser device according to claim 11, wherein the free spectral range is responsible for stabilizing the frequency of the laser in less than 10000 ms, such as less than 1000 ms, such as less than 100 ms.

13. The tunable laser device according to any of the preceding claims, wherein the full-width-at-half-maximum (FWHM) bandwidth of said etalon resonance(s) are configured to be less than 300 MHz, preferably less than 100 MHz, more preferably around 50 MHz.

14. The tunable laser device according to claim 13, wherein said etalon-resonance(s) is/are responsible for suppressing the frequency noise within the locking bandwidth down to less than 10000 Hz$^2$/Hz, preferably less than 100 Hz$^2$/Hz, more preferably less than 1 Hz$^2$/Hz.

15. The tunable laser device according to any of the preceding claims, wherein the stabilizing control-signal back to the tunable fiber laser is via one or more actuators configured to change the tension of the Bragg grating(s) in the first fiber.

FIG. 1

Europäisches
Patentamt

European
Patent Office

Office européen
des brevets

# EUROPEAN SEARCH REPORT

**Application Number**

EP 22 17 3820

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KENJI NUMATA ET AL: "Fiber laser development for LISA", ARXIV.ORG, CORNELL UNIVERSITY LIBRARY, 201 OLIN LIBRARY CORNELL UNIVERSITY ITHACA, NY 14853, 18 March 2010 (2010-03-18), XP080396504, DOI: 10.1088/1742-6596/228/1/012043 * page 2 - page 3; figure 1 * * page 5 * | 1-15 | INV. H01S3/067 H01S5/024 |
| A | SERGIO ROTA-RODRIGO ET AL: "A Switchable Erbium Doped Fiber Ring Laser System for Temperature Sensors Multiplexing", IEEE SENSORS JOURNAL, IEEE, USA, vol. 13, no. 6, 1 June 2013 (2013-06-01), pages 2279-2283, XP011506454, ISSN: 1530-437X, DOI: 10.1109/JSEN.2013.2253093 * abstract; figure 1 * | 1-15 | |
| A | BUI H ET AL: "Novel method of dual fiber Bragg gratings integrated in fiber ring laser for biochemical sensors", MEASUREMENT SCIENCE AND TECHNOLOGY, IOP, BRISTOL, GB, vol. 29, no. 5, 26 March 2018 (2018-03-26), page 55105, XP020326553, ISSN: 0957-0233, DOI: 10.1088/1361-6501/AAA8B0 [retrieved on 2018-03-26] * figure 1(a) * | 1-15 | **TECHNICAL FIELDS SEARCHED** (IPC) H01S |

The present search report has been drawn up for all claims

| Place of search | Date of completion of the search | Examiner |
|---|---|---|
| Munich | 21 October 2022 | Flierl, Patrik |

CATEGORY OF CITED DOCUMENTS

X : particularly relevant if taken alone
Y : particularly relevant if combined with another
　　document of the same category
A : technological background
O : non-written disclosure
P : intermediate document

T : theory or principle underlying the invention
E : earlier patent document, but published on, or
　　after the filing date
D : document cited in the application
L : document cited for other reasons

 ......................................................................
& : member of the same patent family, corresponding
　　document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2013117199 A
- US 20160216369 A
- CN 103986053 A
- WO 20160216369 A

**Non-patent literature cited in the description**

- **FANG WEI et al.** Subkilohertz linewidth reduction of a DFB diode laser using self-injection locking with a fiber Bragg grating Fabry-Perot cavity. *Optics Express,* 25 July 2016, vol. 24 (15), 17406